Europäisches Patentamt

European Patent Office

Office européen des brevets

(11) Numéro de publication : **0 426 583 B1**

## (12) FASCICULE DE BREVET EUROPEEN

(45) Date de publication du fascicule du brevet :
**17.06.92 Bulletin 92/25**

(21) Numéro de dépôt : **90420471.6**

(22) Date de dépôt : **31.10.90**

(51) Int. Cl.⁵ : **H05K 1/00, H05K 3/40**

(54) Circuit imprimé à deux faces, et procédé pour sa fabrication.

(30) Priorité : **03.11.89 FR 8914809**

(43) Date de publication de la demande :
**08.05.91 Bulletin 91/19**

(45) Mention de la délivrance du brevet :
**17.06.92 Bulletin 92/25**

(84) Etats contractants désignés :
**DE ES FR IT**

(56) Documents cités :
**DE-A- 3 509 627**
**GB-A- 2 030 007**
**GB-A- 2 144 271**
**GB-A- 2 163 007**
**US-A- 4 323 593**

(73) Titulaire : **HORLOGERIE PHOTOGRAPHIQUE
FRANCAISE (société anonyme)
Avenue de Savoie
F-74130 Bonneville (FR)**

(72) Inventeur : **Froment, Gérard
89 clos Val Borne
F-74800 Saint Pierre en Faucigny (FR)**
Inventeur : **Zoonnekindt, Roger
Le Crêt
F-74140 Messery (FR)**

(74) Mandataire : **de Beaumont, Michel
Cabinet Poncet 7, chemin de Tillier B.P. 317
F-74008 Annecy Cédex (FR)**

EP 0 426 583 B1

**Description**

La présente invention concerne les circuits imprimés utilisés dans le domaine de l'électronique, par exemple les circuits imprimés utilisés dans la fabrication des postes téléphoniques.

Les circuits imprimés comprennent généralement un substrat en matière isolante, non conductrice de l'électricité, de forme plate, dont les faces sont recouvertes de surfaces ou de pistes conductrices de l'électricité, des trous étant percés dans le substrat pour le passage et la soudure des pattes des composants.

Pour réduire l'encombrement des circuits, les composants sont généralement disposés sur le circuit imprimé de part et d'autre du substrat, sur l'une et l'autre des faces, et chacune des faces est utilisée pour porter des surfaces ou pistes conductrices de l'électricité connectant électriquement les composants. Dans une telle technique, il est nécessaire de prévoir des moyens de conduction électrique reliant certaines pistes ou surfaces conductrices d'une première face de substrat à des pistes ou surfaces conductrices de la seconde face de substrat. Pour ce faire, une technique traditionnelle consiste à prévoir un trou métallisé, c'est-à-dire dont les parois internes sont recouvertes de métal, le métal du trou étant en contact avec l'une et l'autre des pistes ou surfaces conductrices de l'électricité disposées respectivement sur la première et la seconde face du substrat. La difficulté réside alors dans la métallisation du trou, qui est une opération de dépôt électrolytique relativement délicate et onéreuse.

Dans un domaine proche de l'invention, une technologie avantageuse prévoit d'utiliser des pistes conductrices de l'électricité réalisées par sérigraphie d'une pâte sérigraphique chargée en carbone. Cette technique s'avère possible par exemple pour la réalisation des claviers d'ordinateurs et de calculatrices, comme le décrit le document GB-A-2 144 271. Dans ce document, les pistes en pâte sérigraphique chargée en carbone forment elles-mêmes surface de contact électrique pour une pièce mobile de contact. Toutefois, on s'aperçoit que la technologie décrite multiplie les opérations nécessaires pour la réalisation du circuit imprimé : on doit non seulement réaliser les pistes conductrices métalliques sur l'une et l'autre des faces du substrat, mais en outre recouvrir une partie des pistes avec la pâte sérigraphique au carbone pour réaliser la surface de contact. Et le circuit décrit n'est pas adapté pour la réalisation d'un poste téléphonique, car la conductibilité électrique des pistes conductrices en pâte sérigraphiée est trop faible et ne permet pas la connexion des composants électroniques actifs du poste.

Par ailleurs, les documents GB-A-2 030 007 et GB-A-2 163 007 enseignent de réaliser des circuits imprimés à deux faces dont toutes les pistes conductrices sont réalisées en pâte sérigraphiée à base de carbone, et sont connectées, électriquement par ladite pâte traversant des trous du substrat. La résistivité relativement importante et la mauvaise soudabilité de la pâte sérigraphiée ne permettent pas l'utilisation d'une telle structure pour la réalisation des circuits actuels de poste téléphonique.

La présente invention a notamment pour objet de réduire sensiblement la taille des circuits de postes téléphoniques, en permettant d'utiliser une partie de circuit imprimé à pistes de carbone, tout en conservant une conductibilité électrique et une soudabilité suffisamment grandes de la partie de circuit imprimé destinée à connecter électriquement les composants actifs du poste.

Pour cela, l'invention met à profit l'évolution récente des circuits électroniques, notamment des circuits de numérotation téléphonique, qui admettent maintenant des connections électriques présentant des résistances non négligeables, de l'ordre de celles couramment réalisables à l'aide des pâtes sérigraphiques chargées au carbone.

Selon l'invention, une face du circuit peut être entièrement réalisée en piste de carbone, conduisant l'électricité depuis les surfaces de contact en carbone jusqu'au pont de passage entre une première et une seconde faces de circuit imprimé. On évite ainsi d'avoir à réaliser des pistes métalliques depuis le pont de passage jusqu'à la surface de contact en carbone. L'autre face du circuit est réalisée en pistes conductrices métalliques, pour assurer la connexion des composants actifs.

L'invention a également pour avantage de simplifier considérablement la réalisation des ponts conducteurs de l'électricité entre la première et la seconde face de circuit imprimé, sans recourir aux méthodes traditionnelles de métallisation des trous.

En outre, la réalisation d'une partie au moins du pont de passage peut être effectuée simultanément au cours de l'opération de sérigraphie des pistes en carbone.

L'invention permet ainsi de réaliser, de manière simple et économique, des circuits compacts de poste téléphonique présentant de bonnes propriétés de conductibilité électrique et de soudabilité.

En particulier, l'invention permet d'éviter la réalisation des métallisations de trous, procédure relativement complexe, elle permet d'éviter l'apposition de vernis épargne et de pistes cuivre sur la face de circuit imprimé comportant les surfaces de contact en carbone.

Pour atteindre ces objets ainsi que d'autres, une structure de circuit imprimé selon l'invention est telle que :

– une première face de substrat isolant porte des premières surfaces conductrices sérigraphiées à base de carbone,

– une seconde face de substrat isolant porte des secondes pistes conductrices en cuivre,

– le substrat isolant est percé d'au moins un trou traversant débouchant sur la première face du substrat selon un premier orifice, et débouchant sur la seconde face du substrat selon un second orifice, le trou permettant le passage d'un élément conducteur de l'électricité assurant la connexion électrique entre une première surface conductrice sérigraphiée et une seconde piste conductrice en cuivre, le bord du second orifice étant entouré par une portion de ladite seconde piste en cuivre,

– ladite première surface sérigraphiée se poursuit jusqu'au pourtour dudit premier orifice de trou traversant,

– l'élément conducteur de l'électricité est une pâte sérigraphique polymérisée chargée en carbone, logée dans le trou, formant un tube continu reliant les deux orifices du trou et terminé par un premier rebord dépassant et un second rebord dépassant, le second rebord dépassant recouvrant partiellement la seconde piste en cuivre, les rebords dépassants assurant un contact électrique entre le tube continu de l'élément conducteur et ladite piste ou surface conductrice correspondante.

Le procédé de réalisation d'un tel circuit imprimé selon l'invention comprend les étapes suivantes :

(a) réaliser des secondes pistes en cuivre sur la seconde face d'un substrat isolant,

(b) réaliser au moins un trou traversant débouchant sur ladite deuxième face selon un second orifice dont le bord est entouré par une partie de la seconde piste en cuivre,

(c) réaliser des premières surfaces conductrices par sérigraphie d'une pâte conductrice polymérisable à base de carbone, une partie desdites surfaces conductrices formant le bord du premier orifice de trou traversant, de sorte qu'une quantité de pâte conductrice sérigraphique pénètre dans un premier orifice,

(d) forcer la pénétration de pâte conductrice polymérisable dans le trou pour qu'une première portion de ladite pâte tapisse les parois du trou sur au moins la demi-longueur du trou,

(e) chauffer pour polymériser ladit pâte conductrice,

(f) appliquer sur le second orifice du trou une quantité de ladite pâte conductrice polymérisable chargée au carbone de façon qu'une partie de ladite pâte recouvre partiellement ladite seconde piste conductrice en cuivre, et qu'une autre partie de ladite pâte pénètre dans le second orifice du trou,

(g) forcer la pénétration de pâte conductrice polymérisable dans le trou pour que ladite pâte tapisse les parois du trou sur au moins la demi-longueur du trou et rejoigne ainsi la première portion de pâte précédemment introduite par le premier orifice du trou,

(h) chauffer pour polymériser ladite pâte conductrice.

D'autres objets et avantages de la présente invention, ainsi qu'un circuit de numérotation de poste téléphonique utilisant un tel circuit imprimé, ressortiront de la description suivante de modes de réalisation particuliers, faite en relation avec les figures jointes, parmi lesquelles :

– la figure 1 est une vue schématique en coupe d'une portion de circuit imprimé réalisé selon une technologie traditionnelle ;

– la figure 2 représente schématiquement en coupe une portion de circuit imprimé selon l'invention ; et

– les figures 3 à 6 illustrent les étapes du procédé de réalisation du circuit imprimé selon l'invention.

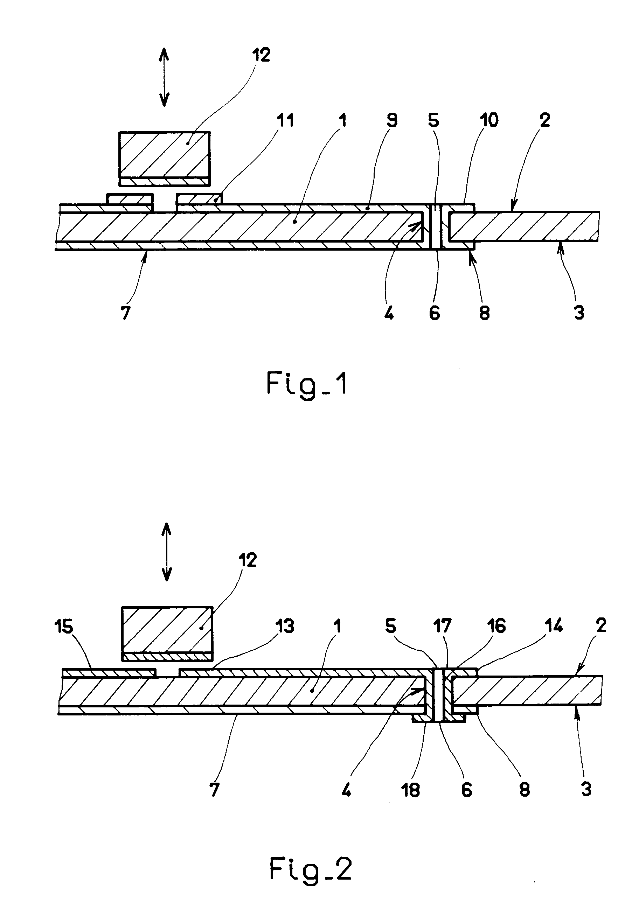

Dans la structure traditionnelle représentée sur la figure 1, le circuit imprimé comprend un substrat 1 isolant en forme de plaque, limité par une première face 2 et une seconde face 3. Le substrat 1 est percé de trous tels que le trou 4 traversant, le trou 4 débouchant sur la première face 2 du substrat selon un premier orifice 5, et débouchant sur la seconde face 3 du substrat selon un second orifice 6.

Le substrat 1 porte, sur sa seconde face 3, une seconde piste conductrice 7 en cuivre, dont une portion 8 entoure le second orifice 6 du trou 4. La première face 2 du substrat 1 porte une première piste conductrice 9 en cuivre, dont une partie 10 entoure le premier orifice 5 du trou 4. Une autre partie de la première piste conductrice 9 en cuivre est recouverte d'une couche sérigraphiée 11 en pâte sérigraphique chargée de carbone. La couche 11 forme surface de contact électrique pour une pièce mobile 12 de contact.

Dans cette technique traditionnelle, le trou 4 est métallisé c'est-à-dire que sa paroi latérale est recouverte d'une couche métallique rejoignant la première piste conductrice 9 et la seconde piste conductrice 7.

La figure 2 illustre une structure de circuit imprimé selon l'invention, dans une configuration similaire à celle de la figure 1. Les éléments similaires sont désignés par les mêmes références numériques, à savoir : le substrat 1, la première face 2, la seconde face 3, le trou 4 avec ses orifices 5 et 6, la seconde piste conductrice 7 et sa portion 8, et la pièce mobile 12.

Par contre, la structure de circuit imprimé selon l'invention diffère par les moyens de conduction électrique entre la pièce mobile 12 et trou 4, et par la structure elle-même des moyens de conduction électrique à l'intérieur du trou 4. En effet, selon l'invention, la connexion électrique à partir de la pièce mobile 12 est assurée par une première surface conductrice sérigraphiée 13 à base de carbone, appliquée directement sur la première face 2 du substrat 1, et se poursuivant depuis la zone occupée par la pièce mobile 12 jusqu'au premier orifice 5 du trou 4. Une partie 14 de ladite première surface conductrice sérigraphiée 13 forme le pourtour du premier orifice 5 de trou 4. La pièce mobile 12 conductrice entre directement en contact avec l'extrémité correspondante de la première surface conductrice sérigraphiée 13, et assure par exemple une connexion électrique entre cette première surface conductrice sérigraphiée 13 et une seconde surface conductrice sérigraphiée correspondante 15, lorsque la pièce mobile 12 est abaissée, le contact étant interrompu lorsque la pièce mobile 12 est relevée.

Dans le trou 4, on dispose selon l'invention un élément conducteur de l'électricité constitué d'une pâte sérigraphique polymérisée chargée en carbone, formant un tube continu 16 reliant les deux orifices 5 et 6 du trou 4. Le tube continu 16 est terminé par un premier rebord dépassant 17 et un second rebord dépassant 18. Les rebords dépassants 17 et 18 assurent le contact électrique respectivement entre l'élément conducteur de l'électricité formé par le tube continu 16 et ladite piste 7 ou surface 13 correspondante.

Dans le mode de réalisation représenté sur la figure 2, le premier rebord dépassant 17 est constitué par la première surface conductrice sérigraphiée 13 elle-même, tandis que le second rebord dépassant 18 est constitué en pâte sérigraphique polymérisée chargée en carbone recouvrant partiellement la seconde piste en cuivre 7.

En alternative, on peut prévoir une structure dans laquelle le premier rebord dépassant 17 est également un rebord dépassant en matière conductrice sérigraphiée polymérisée chargée en carbone, recouvrant partiellement la première surface conductrice sérigraphiée 13.

Dans le mode de réalisation représenté sur la figure 2, la première surface sérigraphiée 13 comporte une partie formant surface de contact électrique pour une pièce mobile de contact 12.

L'invention s'applique toutefois à des circuits imprimés dans lesquels la première surface conductrice sérigraphiée 13 est simplement une surface de dimensions relativement grandes constituant une paroi de blindage connectée électriquement à un potentiel déterminé tel que la masse.

Le mode de réalisation de la figure 2 est utilisé notamment pour réaliser un circuit de numérotation de poste téléphonique. Plusieurs premières surfaces sérigraphiées telles que la surface 13 sont alors agencées sur la première face 2 du substrat 1 pour constituer les surfaces de contact électrique de plusieurs pièces de contact telles que la pièce 12, les pièces de contact 12 étant actionnées par les boutons poussoir du clavier de poste téléphonique et venant sélectivement en contact de deux surfaces sérigraphiées adjacentes telles que les surfaces 13 et 15. La seconde face 3 du substrat 1 porte les pistes conductrices métalliques 7, qui assurent une bonne conduction électrique et une bonne soudabilité pour la connexion des composants actifs du poste téléphonique.

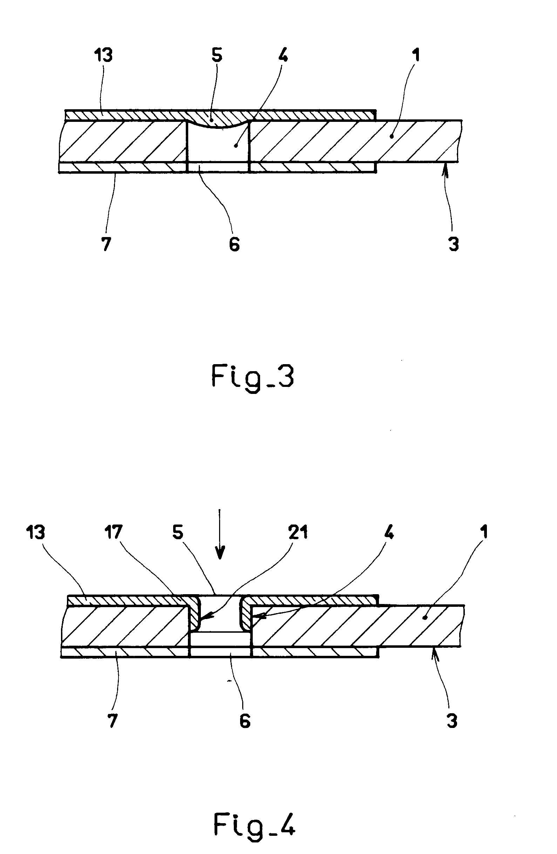

Un procédé de réalisation selon l'invention, pour la constitution des éléments conducteurs de l'électricité insérés dans le trou 4, est illustré sur les figures 3 à 6.

Sur la figure 3, on réalise au préalable, sur le substrat 1, les secondes pistes en cuivre 7 disposées sur la seconde face 3 du substrat ; on réalise également le trou traversant 4 débouchant par les deux orifices 5 et 6. Le bord du second orifice 6 est entouré par une partie de seconde piste 7 conductrice.

On applique ensuite, par sérigraphie, une pâte polymérisable chargée en carbone, pour constituer la première surface conductrice 13. Une partie de ladite surface conductrice 13 recouvre le premier orifice 5 du trou 4.

La pâte polymérisable chargée en carbone utilisée pour l'application par sérigraphie et la formation de la première surface conductrice 13 doit avoir une fluidité appropriée, et être appliquée en une épaisseur appropriée, pour qu'une quantité suffisante de pâte soit introduite dans l'orifice 5 du trou 4 afin de former une partie de l'élément conducteur comme cela sera expliqué ci-après.

Sur la figure 4, on force la pénétration de pâte conductrice polymérisable dans le trou 4 pour que ladite pâte tapisse les parois du trou sur au moins la demi-longueur du trou. Cette étape de forcer la pénétration de pâte conductrice dans le trou peut être assurée soit par entraînement au moyen d'une aiguille introduite de haut en bas dans le trou dans le sens de la pénétration, soit au moyen d'un courant gazeux dans le sens de la pénétration. Par exemple, on peut provoquer une aspiration sur la face inférieure 3 du circuit, provoquant un passage d'air de haut en bas dans le trou 4, le passage d'air entraînant la pâte sérigraphique présente à l'orifice 5 du trou pour la plaquer sur les parois latérales du trou 4 et former une première portion 21 conductrice.

Dans la position de la figure 4, on chauffe alors l'ensemble pour polymériser la pâte conductrice formant la première surface conductrice 13 et la première portion 21 en pâte conductrice tapissant la paroi du trou 4. La partie supérieure de portion 21 en pâte conductrice forme le premier rebord dépassant 17 qui, dans ce mode de réalisation, est continu avec la première surface conductrice 13.

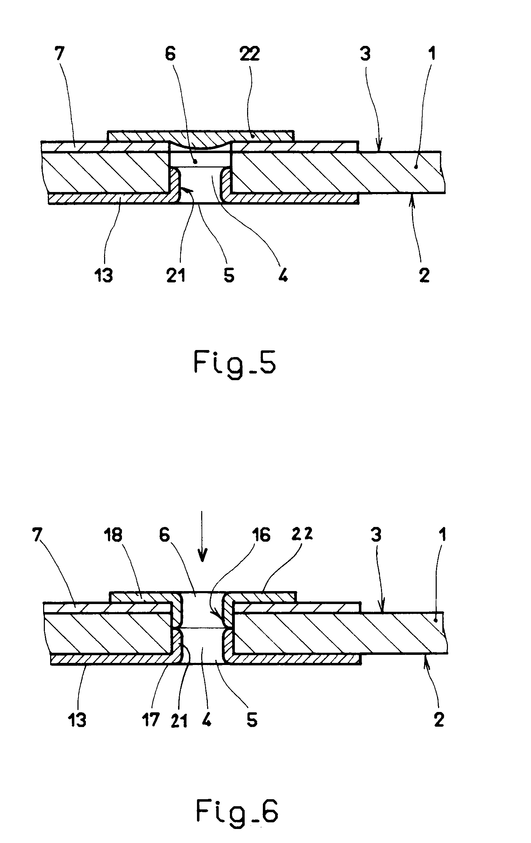

Sur la figure 5, on retourne le circuit imprimé, et on applique, sur le second orifice 6 du trou, une quantité suffisante de la même pâte conductrice polymérisable chargée au carbone, pour former une pastille 22 recouvrant l'orifice 6 et une partie de la seconde piste conductrice 7. La fluidité de la pâte conductrice est la même, de façon à favoriser sa déformation ultérieure et son introduction dans le trou.

Sur la figure 6, on force la pénétration de pâte conductrice polymérisable dans le trou 4 pour que ladite pâte tapisse l'autre portion de paroi du trou, sur au moins la demi-longueur du trou, reliant ainsi la portion extérieure de pastille 22 avec le bord interne de la première portion 21 de pâte sérigraphique conductrice déjà polymérisée. On forme ainsi le second rebord 18 dépassant, et on complète la formation d'un tube continu 16 reliant le premier rebord dépassant 17 et le second rebord dépassant 18. L'opération de forçage de pénétration de pâte conductrice polymérisable dans le trou peut s'effectuer par les mêmes moyens que dans l'étape de la figure 4.

Dans la position de la figure 6, on chauffe alors l'ensemble pour polymériser ladite pâte conductrice non encore polymérisée et formant le second rebord 18 et la partie supérieure du tube continu 16.

Dans le mode de réalisation qui a été explicitement décrit en relation avec les figures 3 à 6, la surface conductrice 13 est formée en même temps que la première portion 21 du tube continu 16. En alternative, la formation de la première surface conductrice peut être réalisée préalablement à la formation du tube continu 16. Dans ce cas, la formation de la première portion 21 du tube continu 16 est réalisée de manière similaire à la formation de la seconde portion de tube continu 16, comme le représentent les figures 5 et 6, par apposition d'une pastille de pâte polymérisable chargée au carbone sur le premier orifice 5 du trou 4, débordant sur une partie de la première surface conductrice 13, puis par forçage de la pâte vers l'intérieur du trou, l'opération complémentaire de formation de la seconde partie du tube continu 16 étant identique à celle représentée sur les figures 5 et 6.

Dans tous les cas, la continuité de matière est assurée entre la première surface conductrice 13 et le premier rebord dépassant 17.

La présente invention n'est pas limitée aux modes de réalisation qui ont été explicitement décrits, mais elle en inclut les diverses variantes et généralisations contenues dans le domaine des revendications ci-après.

## Revendications

1. Circuit imprimé double face, dans lequel :
– une première face (2) de substrat isolant (1) porte des premières surfaces conductrices (13) sérigraphiées à base de carbone,
– une seconde face (3) de substrat isolant (1) porte des secondes pistes conductrices (7) en cuivre,
– le substrat isolant (1) est percé d'au moins un trou traversant (4) débouchant sur la première face (2) du substrat (1) selon un premier orifice (5) et débouchant sur la seconde face (3) du substrat (1) selon un second orifice (6), le trou (4) permettant le passage d'un élément conducteur de l'électricité assurant la connexion électrique entre une première surface conductrice sérigraphiée (13) et une seconde piste conductrice (7) en cuivre, le bord du second orifice (6) étant entouré par une portion (8) de ladite seconde piste (7) en cuivre,
caractérisé en ce que :
– ladite première surface sérigraphiée (13) se poursuit jusqu'au pourtour dudit premier orifice (5) de trou traversant (4),
– l'élément conducteur de l'électricité est une pâte sérigraphique (21) polymérisée chargée en carbone, logée dans ledit trou traversant (4), formant un tube continu (16) reliant les deux orifices (5, 6) du trou (4) et terminé par un premier rebord dépassant (17) et un second rebord dépassant (18), le second rebord dépassant (18) recouvrant partiellement la seconde piste (7) en cuivre, les rebords dépassants assurant un contact électrique entre le tube continu (16) de l'élément conducteur et ladite piste (7) ou surface conductrice (13) correspondante.

2. Circuit imprimé selon la revendication 1, caractérisé en ce que lesdites premières surfaces sérigraphiées (13) comportent une partie formant surface de contact électrique pour une pièce mobile de contact (12).

3. Circuit imprimé selon la revendication 1, caractérisé en ce que lesdites premières surfaces sérigraphiées (13) forment une paroi de blindage connectée électriquement à un potentiel déterminé tel que la masse.

4. Circuit de numéroation de poste téléphonique, comportant un circuit imprimé selon la revendication 2, lesdites premières surfaces sérigraphiées (13) étant agencées pour constituer les surfaces de contact électrique de pièces de contact (12) actionnées par les boutons poussoir du clavier venant sélectivement en contact de deux surfaces sérigraphiées adjacentes (13, 15).

5. Procédé de réalisation d'un circuit imprimé sur un substrat isolant (1) comportant une première face (2) et une seconde face (3), caractérisé en ce qu'il comprend les étapes suivantes :
(a) réaliser des secondes pistes en cuivre (7) sur la seconde face (3) du substrat isolant (1),
(b) réaliser au moins un trou traversant (4), débouchant sur ladite première face (2), et débouchant sur ladite deuxième face (3) selon un second orifice (6) dont le bord est entouré par une partie des secondes pistes (7) en cuivre,
(c) réaliser, sur la première face (2), des premières surfaces conductrices (13) par sérigraphie d'une pâte conductrice polymérisable à base de carbone, une partie (14) desdites surfaces conductrices (13) formant le bord du premier orifice (5) de trou traversant (4), de sorte qu'une quantité de pâte conductrice sérigraphique pénètre dans le premier orifice (5),

(d) forcer la pénétration de pâte conductrice polymérisable dans le trou pour qu'une première portion (21) de ladite pâte tapisse les parois du trou sur au moins la demi-longueur du trou,

(e) chauffer pour polymériser ladite pâte conductrice (21),

(f) appliquer sur le second orifice (6) du trou une quantité (22) de ladite pâte conductrice polymérisable chargée au carbone de façon qu'une partie de ladite pâte recouvre partiellement ladite seconde piste conductrice en cuivre (7), et qu'une autre partie de ladite pâte pénètre dans le second orifice (6) du trou,

(g) forcer la pénétration de pâte conductrice polymérisable dans le trou pour que ladite pâte tapisse les parois du trou sur au moins la demi-longueur du trou et rejoigne ainsi la première portion (21) de pâte précédemment introduite par le premier orifice (5) du trou,

(h) chauffer pour polymériser ladite pâte conductrice.

6. Procédé selon la revendication 5, caractérisé en ce que les étapes d) et/ou g) de forcer la pénétration de pâte conductrice dans le trou sont assurées par entraînement au moyen d'un courant gazeux dans le sens de la pénétration.

7. Procédé selon la revendication 5, caractérisé en ce que les étapes d) et/ou g) de forcer la pénétration de pâte conductrice dans le trou sont assurées par entraînement au moyen d'une aiguille introduite dans le trou dans le sens de la pénétration.

**Patentansprüche**

1. Zweiseitig gedruckte Schaltung, bei welcher
– eine erste Seite (2) eines Isoliersubstrats (1) erste Siebdruck-Leiteroberflächen (13) auf der Basis von Kohlenstoff trägt,
– eine zweite Seite (3) des Isoliersubstrats (1) zweite Leiterbahnen (7) aus Kupfer trägt,
– das Isoliersubstrat (1) mit wenigstens einem Durchgangsloch (4) perforiert ist, welches an der ersten Seite (2) des Substrats (1) mit einer ersten Mündung (5) mündet und an der zweiten Seite (3) des Substrats (1) mit einer zweiten Mündung (6) mündet, wobei das Loch (4) die Passage eines elektrischen Leiterelements erlaubt, mit welchem die elektrische Verbindung zwischen einer ersten Siebdruck-Leiteroberfläche (13) und einer zweiten Leiterbahn (7) aus Kupfer hergestellt wird, wobei der Rand der zweiten Mündung (6) von einem Teil (8) dieser zweiten Leiterbahn (7) aus Kupfer umgeben ist,
dadurch gekennzeichnet, daß
– die erste Siebdruck-Leiteroberfläche (13) bis an den Umfang der ersten Mündung (5) des Durchgangslochs (4) herangeführt ist,
– das elektrische Leiterelement eine Kohlenstoff enthaltende, polymerisierte Siebdruckmasse (21) ist, die in dem Durchgangsloch (4) angeordnet ist und eine die beiden Mündungen (5, 6) des Lochs (4) verbindende durchgehende Röhre (16) ausbildet, welche in einem ersten nach außen überstehenden Rand (17) und in einem zweiten nach außen überstehenden Rand (18) endet, wobei der zweite überstehende Rand (18) die zweite Leiterbahn (7) aus Kupfer teilweise abdeckt und die nach außen überstehenden Ränder eine elektrische Berührung zwischen der durchgehenden Röhre (16) des Leiterelements und der entsprechenden Leiterbahn (7) oder der Leiteroberfläche (13) sicherstellen.

2. Gedruckte Schaltung nach Anspruch 1, dadurch gekennzeichnet, daß die ersten Siebdruck-Oberflächen (13) einen Bereich umfassen, welcher die elektrische Berührungsfläche für ein bewegliches Kontaktstück (12) bildet.

3. Gedruckte Schaltung nach Anspruch 1, dadurch gekennzeichnet, daß die ersten Siebdruck-Oberflächen (13) eine Abschirmfläche bilden, die mit einem vorbestimmten Potential wie die Masse elektrisch verbunden ist.

4. Numerierungsschaltung eines Fernsprechamtes, die eine gedruckte Schaltung nach Anspruch 2 umfaßt, wobei die ersten Siebdruck-Oberflächen (13) zur Ausbildung der elektrischen Kontaktoberflächen der Kontaktstücke (12) eingerichtet sind, welche durch die Kontaktknöpfe der Tastatur betätigt werden, die wahlweise mit zwei benachbarten Siebdruck-Oberflächen (13, 15) in Berührung kommen.

5. Verfahren zur Herstellung einer gedruckten Schaltung auf einem Isoliersubstrat (1), welches eine erste Seite (2) und eine zweite Seite (3) aufweist, dadurch gekennzeichnet, daß es die folgenden Verfahrensstufen aufweist:

(a) Realisierung von zweiten Kupferbahnen (7) auf der zweiten Seite (3) des Isoliersubstrats (1),
(b) Realisierung von wenigstens einem Durchgangsloch (4), das an der ersten Seite (2) mündet und das an dieser zweiten Seite (3) mit einer zweiten Mündung (6) mündet, deren Rand von einem Teil der zweiten Kupferbahnen (7) umgeben ist,
(c) Realisierung von ersten Leiteroberflächen (13) auf der ersten Seite (2) durch einen Siebdruck mit einer polymerisierbaren Leitermasse auf Kohlenstoffbasis, wobei ein Bereich (14) der Leiteroberflächen (13) den Rand der ersten Mündung (5) des Durchgangsloches (4) ausbildet, derart, daß eine Teilmenge der Siebdruck-Leitermasse in die erste Mündung (5) vorsteht,
(d) Erzwingung des Eindringens der polymerisierbaren Leitermasse in das Loch, damit ein erster Teil (21) der Masse die Wände des Lochs wenigstens über die halbe Länge des Lochs bedeckt,

(e) Erwärmung für eine Polymerisation der Leitermasse (21),

(f) Anbringung einer Teilmenge (22) der Kohlenstoff enthaltenden polymerisierbaren Leitermasse auf der zweiten Mündung (6) des Lochs, derart, daß ein Teil dieser Masse die zweite Leiterbahn (7) aus Kupfer teilweise bedeckt und daß ein anderer Teil dieser Masse in die zweite Mündung (6) des Lochs vordringt,

(g) Erzwingung des Eindringens der polymerisierbaren Leitermasse in das Loch, damit diese Masse die Lochwände über wenigstens die halbe Länge des Lochs abdeckt und sich dabei mit dem ersten Teil (21) der Masse vereinigt, die zuvor über die erste Mündung (5) des Lochs eingeführt wurde,

(h) Erwärmung für eine Polymerisation der Leitermasse.

6. Verfahren nach Anspruch 5, dadurch gekennzeichnet, daß Verfahrensschritte (d) und/oder (g) der Erzwingung des Eindringens der Leitermasse in das Loch mit Unterstützung einer Gasströmung in Richtung des Eindringens gewährleistet werden.

7. Verfahren nach Anspruch 5, dadurch gekennzeichnet, daß Verfahrensstufen (d) und/oder (g) der Erzwingung des Eindringens der Leitermasse in das Loch mit Unterstützung durch eine Nadel gewährleistet werden, die in das Loch in Richtung des Eindringens eingeführt wird.

**Claims**

1. A double face printed circuit board, in which;
– a first face (2) of insulating substrate (1) carries the first conductive surfaces (13) which are screen-printed on a carbon base,
– a second face (3) of insulating substrate (1) carries second conductive tracks (7) made of copper,
– the insulating substrate (1) is pierced by at least one through hole (4) opening on to the first face (2) of the substrate (1) in accordance with a first orifice (5), and opening on to the second face (3) of the substrate (1) in accordance with a second orifice (6), the hole (4) enabling insertion of an electrically-conductive element ensuring electrical connection between a first screen-printed conductive surface (13) and a second conductive track (7) made of copper, the edge of the second orifice (6) being surrounded by a portion (8) of said second track (7) made of copper, characterised in that:
– said first screen-printed surface (13) extends as far as the periphery of said first orifice (5) of the through hole (4),
– the electrically-conductive element is a polymerised screen-printing paste (21) charged with carbon, lodged in said through hole (4), forming a continuous tube (16) connecting the two orifices (5, 6) of the hole (4), and terminating in a first proud edge (17), and a second proud edge (18), the second proud edge (18) partially covering the second track (7) made of copper, the proud edges ensuring electrical contact between the continuous tube (16) of the conductive element and the corresponding said track (7) or conductive surface (13).

2. A printed circuit according to Claim 1, characterised in that the said first screen-printed surfaces (13) comprise a portion forming an electrical contact surface for a mobile contact element (12).

3. A printed circuit according to Claim 1, characterised in that the said first screen-printed surfaces (13) form a screening partition electrically connected to a specific potential such as earth.

4. A circuit for telephone number enumeration, comprising a printed circuit according to Claim 2 , said first screen-printed surfaces (13) being disposed so as to constitute the electrical contact surfaces for contact elements (12) actuated by press-buttons of the keypad, and which selectively contact two adjacent screen-printed surfaces (13, 15).

5. A method of manufacturing a circuit printed on an insulating substrate (1) comprising a first face (2) and a second face (3), characterised in that it comprises the following stages:

a) producing second copper tracks (7) on the second face (3) of the insulating substrate (1),

b) producing at least one through hole (4) opening on to said first face (2), and opening on to said second face (3) in accordance with a second orifice (6) whose edge is surrounded by a portion of the second copper tracks (7),

c) producing, on the first face (2), first conductive surfaces (13) by screen-printing of a polymerisable screen-printing paste on a carbon base, one portion (14) of said conductive surfaces (13) forming the edge of the first orifice (5) of the through hole (4), so that a quantity of screen-printing paste penetrates into the first orifice (5),

d) forcing the penetration of polymerisable screen-printing paste into the hole so that a first portion (21) of said paste covers the walls of the hole over half the length of said hole,

e) heating in order to polymerise said conductive paste (21),

f) applying to the second orifice (6) of the hole a quantity (22) of said conductive polymerisable paste charged with carbon, so that said paste partially covers said second conductive copper track (7), and so that another portion of said paste penetrates into the second orifice (6) of the hole,

g) forcing penetration of the conductive polymerisable paste into the hole so that said paste covers the walls of the hole over at least half the length of the hole, thus joining the first portion (21) of paste previously introduced through the first orifice (5) of the hole,

h) heating to polymerise said conductive paste.

6. A method according to Claim 5, characterised in that stages d) and/or g), i.e. forcing penetration of conductive paste into the hole, are ensured by transport by at least one gaseous flow in the direction of penetration.

7. A method according to Claim 5, characterised in that stages d) and/or g), i.e. forcing penetration of conductive paste into the hole, are ensured by means of a needle introduced into the hole in the direction of penetration.

Fig_1

Fig_2

Fig_3

Fig_4

Fig.5

Fig.6